# EUROPÄISCHE PATENTSCHRIFT

(11) **EP 2 593 975 B1**
(45) Veröffentlichungstag und Bekanntmachung des Hinweises auf die Patenterteilung: **28.10.2015**
(21) Anmeldenummer: 11746186.3
(22) Anmeldetag: 08.07.2011
(51) Int. Cl.: H01L 33/60, H01L 33/58, H01L 33/56, H01L 25/075

(54) **STRAHLUNGSEMITTIERENDES BAUELEMENT**
RADIATION-EMITTING COMPONENT
COMPOSANTE ÉMETTRICE DE RAYONNEMENT

(30) Priorität: 15.07.2010 DE 102010027212
(43) Veröffentlichungstag der Anmeldung: 22.05.2013
(73) Patentinhaber: OSRAM Opto Semiconductors GmbH, 93055 Regensburg (DE)
(72) Erfinder: STREPPEL, Ulrich, 93059 Regensburg (DE)
(74) Vertreter: Epping - Hermann - Fischer
(86) Internationale Anmeldenummer: PCT/EP2011/061664
(87) Internationale Veröffentlichungsnummer: WO 2012/007392

(56) Entgegenhaltungen:
- EP-A1- 1 235 281
- WO-A2-2009/041767
- JP-A- 5 037 028
- US-A- 4 009 394
- US-A- 5 893 633
- US-A1- 2004 136 202
- US-A1- 2008 062 682
- US-A1- 2008 185 605
- US-A1- 2009 135 605
- US-A1- 2009 275 266

## Beschreibung

Die Erfindung betrifft ein strahlungsemittierendes Bauelement.

Strahlungsemittierende Bauelemente sind beispielsweise in den Druckschriften US 2008/0062682 A1, US 2008/0185605 A1 und EP 1235281 A1 beschrieben.

Aufgabe der vorliegenden Erfindung ist es, ein strahlungsemittierendes Bauelement anzugeben, das dazu geeignet ist, einen Zielbereich mit einer vorgegebenen Form gemäß einer vorgegebenen Homogenität auszuleuchten.

Diese Aufgabe wird durch ein strahlungsemittierendes Bauelement mit den Merkmalen des Patentanspruchs 1 gelöst. Vorteilhafte Weiterbildungen und Ausführungsformen sind in den abhängigen Ansprüchen angegeben.

Ein solches strahlungsemittierendes Bauelement umfasst insbesondere:
- einen Halbleiterkörper, der dazu vorgesehen ist, elektromagnetische Strahlung von seiner Vorderseite auszusenden,
- ein reflektierendes optisches Element mit mehreren schrägen, reflektierenden Seitenflächen, die umlaufend um den Halbleiterkörper angeordnet sind, und
- ein refraktives optisches Element, das dem reflektierenden optischen Element in Abstrahlrichtung des Halbleiterkörpers nachgeordnet ist.

Der Halbleiterkörper ist dazu vorgesehen, elektromagnetische Strahlung von seiner Vorderseite auszusenden, so dass ein erster Teil der Strahlung direkt auf das optische reflektierende Element und ein zweiter Teil der Strahlung direkt auf das refraktive optische Element trifft, wobei das reflektierende optische Element dazu vorgesehen ist, den ersten Teil der Strahlung in Richtung eines Außenbereichs eines auszuleuchtenden Zielbereichs zu lenken und das refraktive optische Element dazu vorgesehen ist, den ersten Teil der Strahlung in den Außenbereich des Zielbereichs zu bündeln und den zweiten Teil der Strahlung in einen Innenbereich der Strahlung zu bündeln.

Das refraktive optische Element ist bevorzugt derart angeordnet, dass ein Großteil der von dem Halbleiterkörper ausgesandten Strahlung durch das refraktive optische Element hindurch tritt. Beispielsweise ist das refraktive optische Element der Vorderseite des Halbleiterkörpers in dessen Abstrahlrichtung nachgeordnet.

In der Regel emittieren Halbleiterkörper Strahlung von ihrer Vorderseite unter unterschiedlichen Austrittswinkeln. Das vorliegende strahlungsemittierende Bauelement beruht auf dem Gedanken, dass der erste Teil der Strahlung, der unter einem vergleichsweise flachen Winkel α (α ist hierbei bezogen auf die Vorderseite) von der Vorderseite des Halbleiterkörpers ausgesandt wird, zuerst auf das reflektierende optische Element trifft, bevor sie das refraktive optische Element durchläuft. Der Winkel α zwischen der Vorderseite des Halbleiterkörpers und der emittierten Strahlung ist nicht größer als 60°.

Der erste Teil der Strahlung, der auf das reflektive optische Element auftrifft, wird zuerst von dem reflektiven optischen Element in Richtung eines äußeren Bereichs des Zielbereichs gelenkt. Anschließend durchläuft der erste Teil der Strahlung einen äußeren Bereich des refraktiven optischen Elements und wird durch dieses auf gewünschte Art und Weise korrigiert, beispielsweise weiter in den Zielbereich gebündelt. Durch vorherige Umlenkung mittels des reflektiven optischen Elements kann die notwendige Wirkung des refraktiven optischen Elements auf die Strahlung vorteilhafterweise verringert werden. Daher können bei dem strahlungsemittierenden Bauelement mit Vorteil in der Regel refraktive Elemente mit geringer Höhe zum Einsatz kommen und Fresnelverluste vermindert werden.

Besonders bevorzugt beträgt das Verhältnis zwischen der maximalen Höhle des Bauelements zur Breite des Halbleiterkörpers zwischen 1,5 und 3, wobei die Grenzen eingeschlossen sind.

Der zweite Teil der Strahlung hingegen, der von dem Halbleiterkörper unter einem vergleichsweise steilen Winkel α von dessen Vorderseite ausgesandt wird, tritt direkt durch das refraktive optische Element ohne zuerst auf das reflektive optische Element aufzutreffen. Der zweite Teil der Strahlung wird von dem refraktiven optischen Element in einen Innenbereich des Zielbereichs gebündelt.

Bei dem strahlungsemittierenden Bauelement wird somit die Strahlung des Halbleiterkörpers, die in einem flachen Winkel von der Vorderseite des Halbleiterkörpers ausgesandt wird, getrennt von der Strahlung geführt, die in einem steilen Winkel von der Vorderseite des Halbleiterkörpers ausgesandt wird. Auf diese Art und Weise kann zum einen die Höhe des Bauelement vorteilhafterweise verringert und dessen Effizient erhöht werden.

Ein reflektierendes optisches Element, das dazu geeignet ist, den ersten Teil der Strahlung in Richtung des Außenbereichs eines Zielbereichs zu lenken, der eine vorgegebene, bevorzugt nicht rotatationsymmetrische Form aufweist, weist in der Regel mehrere schräge reflektierende Seitenflächen auf, die umlaufend um den Halbleiterkörper angeordnet sind. Hierdurch können vorteilhafterweise auch Randbereiche des Außenbereichs, die bevorzugt von der Rotationssymmetrie abweichen, möglichst homogen ausgeleuchtet werden.

Besonders bevorzugt ist der Zielbereich durch eine rechteckige Fläche gegeben. Ein solches strahlungsemittierendes Bauelement kann beispielsweise als Blitzlicht für ein Mobiltelefon verwendet werden. Ist der Zielbereich durch eine rechteckige Fläche gegeben, so ist diese rechteckige Fläche bevorzugt derart homogen ausgeleuchtet, dass die relative Beleuchtungsstärke in den Eckpunkten B des Zielbereichs zwischen 15% und 25% der Beleuchtungsstärke im Mittelpunkt A des Rechtecks aufweist.

Weiterhin weisen die Punkte C der rechteckigen Fläche, die jeweils auf einer Verbindungslinie zwischen den Eckpunkten B der rechteckigen Fläche und dem Mittelpunkt A der rechteckigen Fläche liegen, bevorzugt eine relative Beleuchtungsstärke zwischen 55% und 75% der Beleuchtungsstärke im Mittelpunkt A der rechteckigen Fläche auf. Hierbei beträgt das Verhältnis der Strecke AC zu der Strecke AB jeweils zwischen 0,65 und 0,75 liegt, wobei die Grenzen eingeschlossen sind.

Die Seitenflächen des optischen reflektierenden Elements begrenzen eine erste Öffnung, die zu dem Halbleiterkörper hingewandt ist und eine zweite Öffnung, die von dem Halbleiterkörper abgewandt ist. Bevorzugt begrenzt die erste Öffnung eine Fläche, die zu der Fläche, die von der zweiten Öffnung begrenzt wird, geometrisch ähnlich ist. Besonders bevorzugt sind die Flächen, die von der ersten und der zweiten Öffnung des reflektierenden optischen Elements begrenzt werden weiterhin geometrisch ähnlich zu dem Zielbereich. Ist die Fläche die durch die erste und/oder die zweite Öffnung des reflektierenden optischen Elements begrenzt wird, geometrisch ähnlich zu dem Zielbereich, so ist das reflektierende optische Element an den Zielbereich angepasst.

Die erste Öffnung kann eine rechteckige Fläche begrenzen. Besonders bevorzugt weist das reflektierende optische Element hierbei vier schräge Seitenflächen auf und eine zweite Öffnung auf, die ebenfalls eine rechteckige Fläche begrenzt. Mit Hilfe eines solchen reflektierenden Elements kann mit Vorteil ein rechteckiger Zielbereich möglichst homogen ausgeleuchtet werden.

Die Erfindung umfasst, dass die erste und/oder die zweite Öffnung des reflektierenden Elements eine achteckige Fläche begrenzt. Das reflektierende Element weist hierbei bevorzugt acht schräge Seitenflächen auf. Die Kanten der schrägen Seitenfläche bilden jeweils bevorzugt die erste und/oder die zweite Öffnung. Die acht zur optischen Achse des Bauelements schräg verlaufenden Seitenflächen des reflektierenden Elements sind bevorzugt zu einer Mantelfläche eines Pyramidenstumpfes mit einer achteckigen Grundfläche angeordnet. Auch ein solches reflektierendes Element ist insbesondere dazu geeignet, einen rechteckigen Zielbereich möglichst homogen auszuleuchten. Mit Hilfe der zusätzlichen vier schrägen Seitenflächen ist es vorteilhafterweise möglich, Strahlung auch in die Ecken des rechteckigen Zielbereichs zu lenken.

Besonders bevorzugt ist zumindest eine schräge Seitenfläche des reflektierenden optischen Elements gekrümmt ausgebildet. Die Krümmung kann hierbei beispielsweise parabolisch, elliptisch oder hyperbolisch ausgebildet sein. Gemäß einer Ausführungsform ist zumindest eine Seitenfläche des reflektierenden optischen Elements als zusammengesetzter parabolischer Konzentrator (compound parabolic concentrator - CPC), als zusammengesetzter elliptischer Konzentrator (compound ellipitic concentrator - CEC) oder als zusammengesetzter hyperbolischer Konzentrator (compound hyperbolic concentrator - CHC) ausgebildet.

Gemäß einer weiteren bevorzugten Ausführungsform ist die Form des refraktiven optischen Elements an die Form des Zielbereichs angepasst. Dies bedeutet beispielsweise, dass eine Grundfläche des refraktiven optischen Elements dem Zielbereich geometrisch ähnlich ist. Insbesondere ist es möglich, dass das refraktive optische Element selbst oder dessen Grundfläche keine Rotationssymmetrie aufweist. Hierdurch kann ein Zielbereich mit einer vorgegeben Form, beispielsweise rechteckig, möglichst homogen ausgeleuchtet werden.

Insbesondere ist es möglich, dass das refraktive optische Element selbst oder seine erste und/oder zweite Öffnung keine Rotationssymmetrie aufweist. Hierdurch kann ein Zielbereich mit einer vorgegeben Form, beispielsweise rechteckig, möglichst homogen ausgeleuchtet werden.

Als refraktives optisches Element kann beispielsweise eine Fresnellinse, eine bikonische Linse, eine torische Linse, eine Linse mit einer Außenfläche gemäß einem x,y-Polynom, eine Plankonvexlinse, eine Bikonvexlinse, ein Linsenarray oder eine segmentierte Linse eingesetzt sein.

Eine bikonische Linse weist hierbei unterschiedliche konische Konstanten entlang zweier, aufeinander senkrecht stehender Achsen innerhalb ihrer Grundfläche auf. Hierdurch kann vorteilhafterweise eine ovale Ausleuchtung, die an die Symmetrie eines rechteckigen Zielbereichs angepasst ist, realisiert werden.

Eine Linse, deren Außenfläche gemäß einem x,y-Polynom geformt ist, weist in der Regel den Vorteil auf, besonders zur Ausleuchtung eines rechteckigen Zielbereichs geeignet zu sein.

Eine segmentierte Linse weist bevorzugt mehrere Linsensegmente auf. Beispielsweise weist die segmentierte Linse ein zentrales Linsensegment auf, das von mehreren äußeren Segmenten umgeben ist. Bevorzugt grenzt das zentrale Linsensegment direkt an die äußeren Segmente an, dass heißt, dass eine Umrandung des zentralen Linsensegments jeweils mit einer Umrandung eines äußeren Segments eine gemeinsame Grenzlinie ausbildet. Weiterhin weist das zentrale Linsensegment bevorzugt eine Grundfläche auf, die ähnlich zu dem Zielbereich ausgebildet ist. Weiterhin weist die segmentierte Linse bevorzugt die gleiche Anzahl an äußeren Linsensegmenten auf, wie die Anzahl an reflektierenden Seitenflächen des reflektierenden Elements. Die Segmente der Linse sind bevorzugt nach außen gewölbt, beispielsweise bikonisch oder gemäß einem x,y-Polynom.

Weiterhin sind die Linsensegmente bevorzugt derart ausgebildet und angeordnet, dass Strahlung, die nicht auf die reflektierenden Seitenflächen auftrifft, das zentrale Linsensegment durchläuft, während Strahlung, die auf die Seitenflächen des reflektierenden Elements auftrifft, durch die äußeren Linsensegmente hindurch läuft. Besonders bevorzugt ist hierbei jeweils einer reflektierenden Seitenfläche des reflektierenden Elements ein äußeres Linsensegment des refraktiven Elements zugeordnet, dass heißt, dass Strahlung, die von einer bestimmten Seitenfläche reflektiert wird, dazu vorgesehen ist ein bestimmtes äußeres Linsensegment zu durchlaufen.

Weiterhin kann das refraktive optische Element, wie beispielsweise eine der oben genannten Linsen, eine quadrantensymmetrische, beispielsweise elliptische Form aufweisen.

Ein refraktives optisches Element mit einer quadrantensymmetrischen Form weist in der Regel eine rechteckige Grundfläche auf und kann insbesondere dazu verwendet sein, einen rechteckigen Zielbereich möglichst homogen auszuleuchten.

Gemäß einer weiteren Ausführungsform des strahlungsemittierenden Bauelements ist der Halbleiterkörper in einen Verguss eingebettet. Der Verguss kann beispielsweise als zusätzliche Linse oder als Schicht ausgebildet sein.

Hierbei ist es möglich, dass der Verguss direkt an das refraktive optische Element angrenzt, das heißt, eine gemeinsame Grenzfläche mit dem refraktiven Element ausbildet. Ist das refraktive optische Element beispielsweise auf einer ersten Hauptseite des reflektierenden optischen Elements angebracht, so füllt bei dieser Ausführungsform der Verguss das gesamte reflektierende optische Element bis hin zu dem refraktiven optischen Element vollständig aus.

Alternativ hierzu ist es auch möglich, dass zwischen dem Verguss und dem refraktiven optischen Element ein luftgefüllter Raum ausgebildet ist.

Der Verguss enthält beispielsweise ein Epoxidmaterial, ein Silikonmaterial oder eine Mischung aus einem Silikonmaterial mit einem Epoxidmaterial. Weiterhin kann der Verguss auch aus einem Epoxidmaterial, einem Silikonmaterial oder einer Mischung aus einem Silikonmaterial mit einem Epoxidmaterial bestehen.

Gemäß einer weiteren Ausführungsform umfasst das strahlungsemittierende Bauelement einen Wellenlängenkonversionsstoff, der einen Teil der von dem Halbleiterkörper erzeugten Strahlung in Strahlung eines anderen Wellenlängenbereichs umwandelt.

Der Wellenlängenkonversionsstoff kann beispielsweise aus der Gruppe der Materialien gewählt sein, die durch die folgenden Materialien gebildet werden: mit Metallen der seltenen Erden dotierte Granate, mit Metallen der seltenen Erden dotierte Erdalkalisulfide, mit Metallen der seltenen Erden dotierte Thiogalate, mit Metallen der seltenen Erden dotierte Aluminate, mit Metallen der seltenen Erden dotierte Orthosilikate, mit Metallen der seltenen Erden dotierte Chlorosilikate, mit Metallen der seltenen Erden dotierte Erdalkalisiliziumnitride, mit Metallen der seltenen Erden dotierte Oxynitride und mit Metallen der seltenen Erden dotierte Aluminiumoxinitride.

Besonders bevorzugt sendet der Halbleiterkörper hierbei Strahlung aus dem blauen Spektralbereich aus, die teilweise durch den Wellenlängenkonversionsstoff in Strahlung des gelben Spektralbereiches umgewandelt wird. Bevorzugt mischen sich hierbei die unkonvertierte blaue Strahlung und die konvertierte gelbe Strahlung, so dass weiße Mischstrahlung erzeugt wird. Als Wellenlängenkonversionsstoff, der blaue Strahlung in gelbe Strahlung umwandelt, ist beispielsweise YAG:Ce geeignet.

Der Wellenlängenkonversionsstoff kann beispielsweise in den Verguss eingebettet sein, wobei der Verguss beispielsweise als zusätzliche Linse oder als Schicht ausgebildet ist, wie bereits oben beschrieben. Ist der Wellenlängenkonversionsstoff in einer Schicht aus Vergussmaterial auf dem Halbleiterkörper angeordnet, so ist es weiterhin möglich, dass der Halbleiterkörper mit der wellenlängenkonvertierenden Schicht in einen Verguss eingebettet ist, der als Linse ausgebildet und frei von Wellenlängenkonversionsstoff ist.

Weiterhin kann der Wellenlängenkonversionsstoff auch in Form eines keramischen Plättchens vorliegen, dass bevorzugt auf der strahlungsemittierenden Vorderseite des Halbleiterkörpers angeordnet ist. Das keramische Plättchen ist bevorzugt in direktem Kontakt mit der Vorderseite des Halbleiterkörpers angeordnet, so dass das keramische Plättchen eine gemeinsame Grenzfläche mit der Vorderseite des Halbleiterkörpers ausbildet.

Gemäß einer weiteren Ausführungsform umfasst das strahlungsemittierende Bauelement eine diffus streuende Schicht, beispielsweise ein diffus streuendes Plättchen oder eine diffus streuende Folie. Die diffus streuende Schicht ist dem Halbleiterkörper bevorzugt in dessen Abstrahlrichtung nachgeordnet. Die diffus streuende Schicht ist insbesondere bei einem Bauelement mit einem Wellenlängenkonversionsstoff verwendet, um einen Farbeindruck des Wellenlängenkonversionsstoffs für einen externen Betrachter zu kaschieren. Ist der Wellenlängenkonversionsstoff beispielsweise in einen Verguss in Form einer Schicht eingebracht, der den Halbleiterkörper einhüllt, so ist die diffus streuende Schicht bevorzugt in direktem Kontakt auf den Verguss mit dem Wellenlängenkonversionsstoff aufgebracht, so dass die diffus streuende Schicht und der Verguss eine gemeinsame Grenzfläche ausbilden. Dies ist bevorzugt auch der Fall, wenn der Wellenlängenkonversionsstoff in Form eines keramischen Plättchens vorliegt.

Gemäß einer weiteren Ausführungsform ist in der Umgebung des Halbleiterkörpers ein reflektiver Verguss angeordnet. Hierzu enthält der reflektive Verguss bevorzugt Titanoxidpartikel. Beispielsweise ist der reflektive Verguss seitlich des Halbleiterkörpers, bevorzugt bis zu dessen aktiver strahlungsemittierender Zone oder zu dessen strahlungsemittierender Vorderseite in direktem Kontakt mit den Seitenflächen des Halbleiterkörpers angeordnet. Der reflektierende Verguss verringert mit Vorteil Strahlungsverluste über Seitenflächen des Halbleiterkörpers und trägt dazu bei, die Strahlung des Halbleiterkörpers in Richtung des refraktiven Elements zu richten.

Der reflektive Verguss umfasst beispielsweise ein Matrixmaterial, wie etwa Silikon, in das reflektierende Partikel, beispielsweise Titanoxidpartikel, eingebracht sind.

Gemäß einer Ausführungsform ist der Halbleiterkörper auf einem Substrat aufgebracht. Das reflektierende optische Element ist hierbei bevorzugt ebenfalls auf dem Substrat befestigt, beispielsweise mittels Kleben.

Gemäß einer Ausführungsform weist das reflektierende optische Element auf einer Hauptseite, die von dem Halbleiterkörper angewandt ist, eine Aussparung auf, die dazu vorgesehen ist, das refraktive optische Element aufzunehmen. Besonders bevorzugt ist das refraktive optische Element bündig in die Aussparung des reflektierenden optischen Elements eingepasst. Mit Hilfe einer solchen Aussparung kann das refraktive optische Element auf einfache Art und Weise zu dem Halbleiterkörper justiert angeordnet werden.

Gemäß einer weiteren Ausführungsform weist das strahlungsemittierende Bauelement zwei oder mehr strahlungsemittierenden Halbleiterkörper auf. Die Halbleiterkörper sind hierbei bevorzugt rotationssymmetrisch zu einer optischen Achse des refraktiven optischen Elements angeordnet. Alle Merkmale, die vorliegend in Zusammenhang mit einem Halbleiterkörper beschrieben sind, können ebenfalls mit zwei oder mehreren Halbleiterkörpern Verwendung finden.

Weitere vorteilhafte Ausführungsformen und Weiterbildungen der Erfindung ergeben sich aus den im Folgenden in Verbindung mit den Figuren beschriebenen Bauelementen und dem Ausführungsbeispiel.
- Figur 1A: zeigt eine schematische Schnittdarstellung eines strahlungsemittierenden Bauelements.
- Figur 1B: zeigt eine schematische perspektivische Darstellung des strahlungsemittierenden Bauelements gemäß Figur 1A.
- Figur 2 und Figur 3A: zeigen schematische Schnittdarstellungen zweier weiterer strahlungsemittierender Bauelemente.
- Figuren 3B: und 3C zeigen schematische perspektivische Darstellungen des strahlungsemittierenden Bauelements gemäß Figur 3A.
- Figur 4A: zeigt beispielhaft eine maßstäbliche Schnittdarstellung eines Bauelements gemäß der Figuren 3A, 3B und 3C.
- Figur 4B: zeigt beispielhaft eine maßstäbliche Draufsicht auf das Bauelement gemäß der Figuren 3A, 3B und 3C.
- Figuren 5A und 5B: zeigen schematische perspektivische Darstellungen eines strahlungsemittierenden Bauelements gemäß einem Ausführungsbeispiel.
- Figuren 6 bis 11: zeigen schematische Schnittdarstellungen weiterer strahlungsemittierender Bauelemente.
- Figuren 12A und 12B: zeigen schematische Darstellung eines weiteren strahlungsemittierenden Bauelements.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten, falls nicht explizit anders angegeben. Vielmehr können einzelne Elemente, insbesondere Schichtdicken zur besseren Darstellbarkeit und/oder zum besseren Verständnis übertrieben groß dargestellt sein.

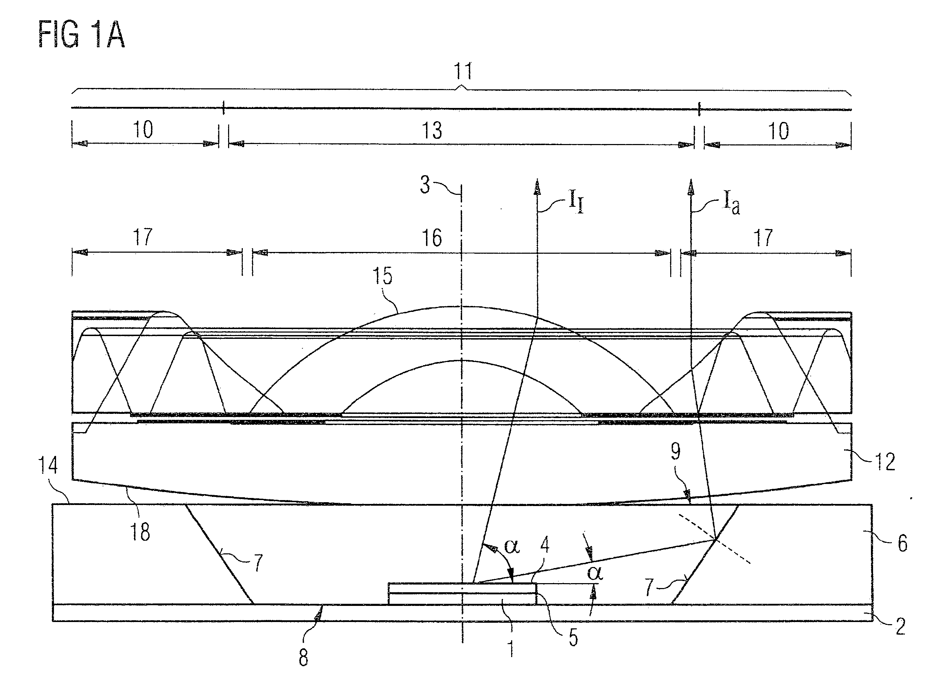

Das strahlungsemittierende Bauelement gemäß der Figur 1A umfasst einen Halbleiterkörper 1, der auf einem Substrat 2 befestigt ist. Der Halbleiterkörper 1 ist zentriert zur optischen Achse 3 des Bauelements angeordnet.

Der Halbleiterkörper 1 ist dazu vorgesehen, von seiner Vorderseite 4 elektromagnetische Strahlung eines ersten Wellenlängenbereichs auszusenden. Der Halbleiterkörper 1 weist hierzu eine aktive Zone 5 auf, die im Betrieb des Bauelements elektromagnetische Strahlung erzeugt. Die aktive Zone 5 umfasst bevorzugt einen pn-Übergang, eine Doppelheterostruktur, einen Einfach-Quantentopf oder besonders bevorzugt eine Mehrfach-Quantentopfstruktur (MQW) zur Strahlungserzeugung. Die Bezeichnung Quantentopfstruktur beinhaltet hierbei keine Angabe über die Dimensionalität der Quantisierung. Sie umfasst somit u.a. Quantentröge, Quantendrähte und Quantenpunkte und jede Kombination dieser Strukturen.

Das Bauelement weist weiterhin ein reflektierendes optisches Element 6 auf, das ebenfalls auf dem Substrat 2 angeordnet ist.

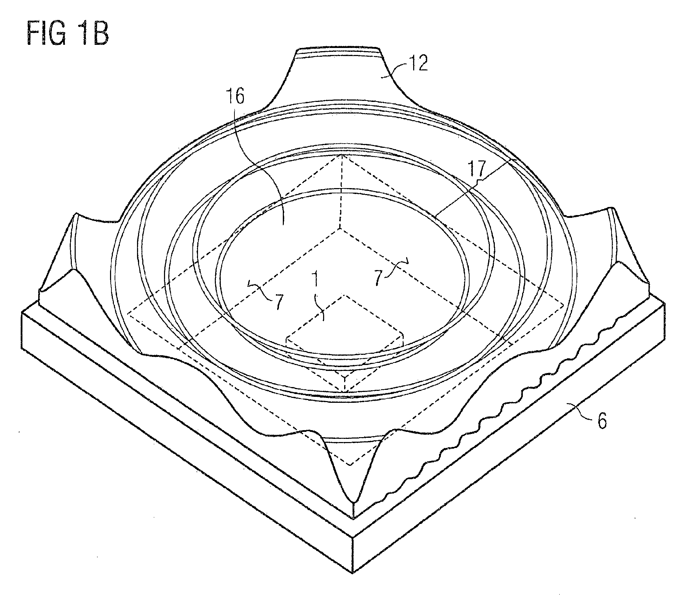

Wie in Figur 1B gezeigt, weist das reflektierende optische Element 6 vier schräge Seitenflächen 7 auf, dazu vorgesehen sind, einen ersten Teil der Strahlung, die unter einem flachen Winkel α von der Vorderseite 4 des Halbleiterkörpers 1 ausgesandt wird, zu reflektieren. Weiterhin weist das reflektierende optische Element 6 eine erste Öffnung 8 auf, die von den Seitenflächen 7 begrenzt wird und zu dem Halbleiterkörper 1 hingewandt ist. Die erste Öffnung 8 des reflektierenden optischen Elements 6 begrenzt hierbei eine rechteckige Fläche. Der Halbleiterkörper 1 ist zentriert innerhalb dieser rechteckigen Fläche angeordnet.

Weiterhin weist das reflektierende Element 6 eine zweite Öffnung 9 auf, die von dem Halbleiterkörper 1 abgewandt ist und ebenfalls durch die Seitenflächen 7 begrenzt wird. Die zweite Öffnung 9 des reflektierenden Elements 6 begrenzt ebenfalls eine rechteckige Fläche.

Die schrägen Seitenflächen 7 des reflektierenden optischen Elements 6 sind dazu vorgesehen, den ersten Teil der von dem Halbleiterkörper 1 ausgesandten Strahlung, der direkt auf das reflektierende optische Element 6 auftrifft, in einen Außenbereich 10 eines Zielbereichs 11 zu lenken. Hierzu sind die Seitenflächen 7 bevorzugt gekrümmt ausgebildet. Der Zielbereich 7 ist vorliegend durch eine rechteckige Fläche gegeben.

Weiterhin umfasst das strahlungsemittierende Bauelement ein refraktives optisches Element 12, das dazu vorgesehen ist, den ersten, reflektierten Anteil der Strahlung in den Außenbereich 10 des zielbereichs 11 zu bündeln und den zweiten Strahlungsanteil in einen Innenbereich 13 des Zielbereichs 11 zu bündeln. Das refraktive optische Element 12 ist vorliegend auf einer ersten Hauptseite 14 des reflektierenden optischen Elements 6 angeordnet, die von dem Halbleiterkörper 1 abgewandt ist. Das refraktive optische Element 12 ist somit der Vorderseite 4 des Halbleiterkörpers 1 in dessen Abstrahlrichtung nachgeordnet.

Eine Außenseite 15 des refraktiven optischen Elements 12, die von dem Halbleiterkörper 1 abgewandt ist, weist einen Innenbereich 16 mit einer konkaven Wölbung nach außen auf. Bevorzugt ist der Innenbereich 16 der Außenseite 15 konisch ausgebildet. In einem Außenbereich 17 der Außenseite 15, der umlaufend um den Innenbereich 16 angeordnet ist, weist das refraktive optische Element 12 prismatische ringförmige Fresnelstrukturen auf. Die prismatischen Fresnelstrukturen sind in konzentrischen Ringstrukturen umlaufend um den Innenbereich 16 des refraktiven optischen Elements 12 angeordnet. Die Fresnelstrukturen sind dazu geeignet, den ersten Teil der Strahlung, der von den Seitenwänden 7 reflektiert wird, in den rechteckigen Zielbereich 11 zu bündeln. Das refraktive optische Element 12 weist vorliegend Rotationssymmetrie zur optischen Achse 3 auf. Prinzipiell ist aber auch ein refraktives optisches Element 12 mit elliptischer oder quantensymmetrischer Form denkbar. Die Rückseite 18 des refraktiven optischen Elements 12, die zu dem Halbleiterkörper 1 hingewandt ist, ist konvex nach außen gewölbt. Vorzugsweise ist die Rückseite 18 des refraktiven optischen Elements 12 konisch ausgebildet.

Wie Figur 1A zeigt, trifft ein Strahl Iₐ, der unter einem vergleichsweise flachen Winkel α von der Vorderseite 4 des Halbleiterkörpers 1 emittiert wird, auf die schräge Seitenfläche 7 des reflektierenden optischen Elements 6 auf und wird von dieser in Richtung der Fresnelstrukturen im Außenbereich 17 des refraktiven Elements 12 reflektiert. Der Strahl Iₐ verläuft von der reflektierenden Seitenfläche 7 des reflektierenden Elements 6 durch das refraktive optische Element 12 hindurch und wird durch die Fresnelstrukturen des refraktiven Elements 12 weiter in den Außenbereich 10 des Zielbereichs 11 gelenkt.

Ein Strahl Iᵢ, der unter einem vergleichsweise steilen Winkel α von der Vorderseite 4 des Halbleiterkörpers 1 ausgesandt wird, trifft nicht auf eine der reflektierenden Seitenflächen 7 auf, sondern durchläuft das refraktive optische Element 12 direkt. Der Strahl Iᵢ durchläuft den Innenbereich 16 des refraktiven optischen Elements 12 und wird durch dessen konkave Außenseite in einen Innenbereich 13 des Zielbereichs 11 gebündelt.

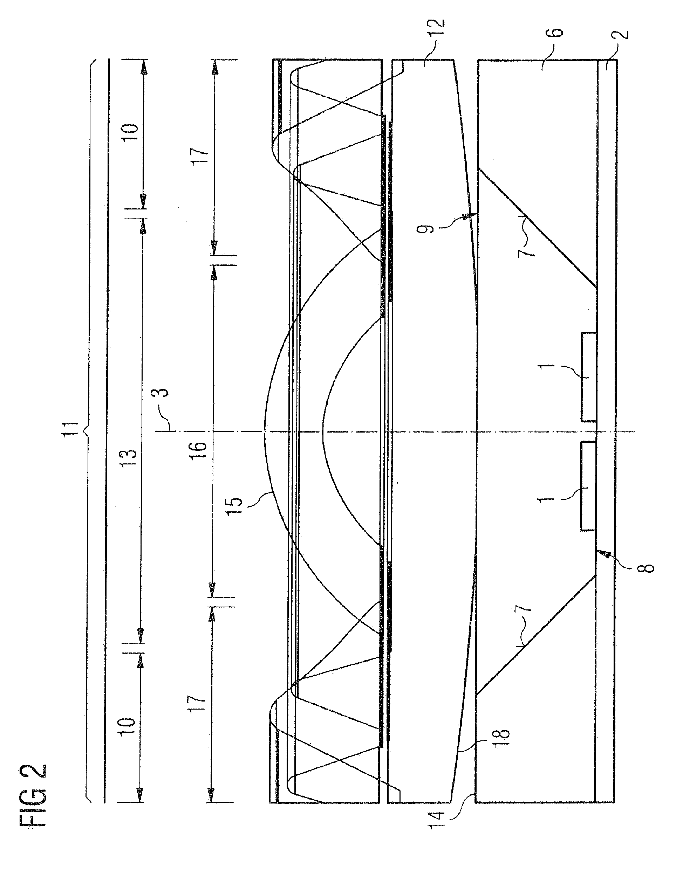

Das Bauelement gemäß der Figur 2 weist im Unterschied zu dem Bauelement der Figuren 1A und 1B zwei strahlungsemittierende Halbleiterkörper 1 auf. Die Halbleiterkörper 1 sind hierbei symmetrisch zur optischen Achse 3 des Bauelements angeordnet. Das reflektierende optische Element 6 weist weiterhin eine größere Höhe auf, als das Bauelement der Figuren 1A und 1B, so dass die reflektierenden Seitenflächen 7 eine größere Fläche aufweisen. Da bei dem Bauelement gemäß der Figur 2 eine größere Ausdehnung der Strahlungsquelle vorliegt, da zwei statt einem Halbleiterkörper 1 verwendet sind, ist ein größerer Flächeninhalt der reflektierenden Seitenflächen 7 notwendig, um den Zielbereich 11 möglichst homogen auszuleuchten. Bei der Verwendung zweier Halbleiterkörper steigt die Höhe des reflektierenden Elements in der Regel um einen Faktor an, der zwischen 1,2 und 1,7 liegt, wobei die Grenzen eingeschlossen sind.

Es sei an dieser Stelle darauf hingewiesen, dass statt zwei Halbleiterkörpern 1, die bevorzugt nebeneinander symmetrisch zur optischen Achse 3 des Bauelements angeordnet sind, auch mehrere Halbleiterkörper 1 verwendet sein können, wobei diese bevorzugt ebenfalls symmetrisch zur optischen Achse 3 des Bauelements angeordnet sind. Beispielsweise können die Halbleiterkörper 1 als Matrix angeordnet sein.

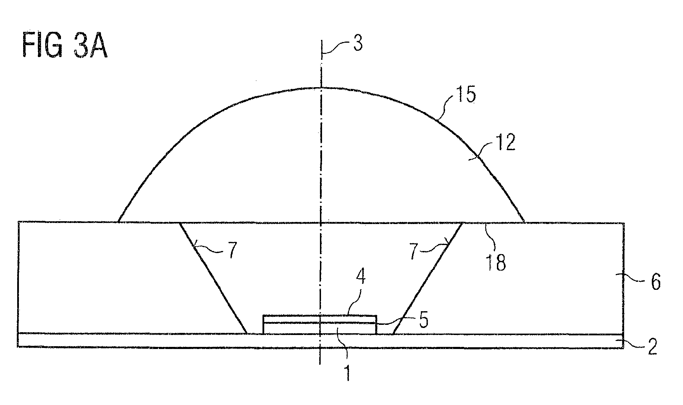

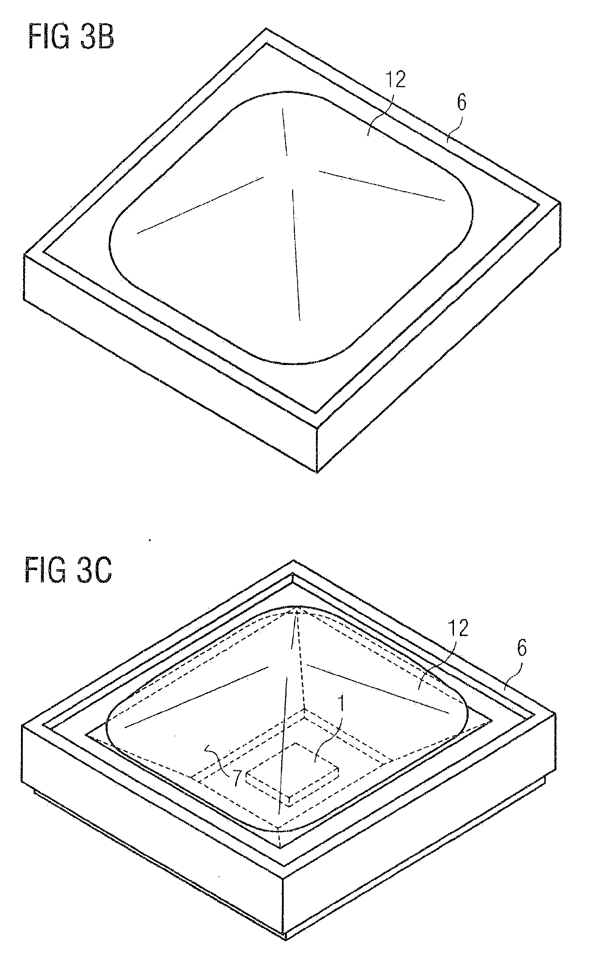

Bei dem Bauelement gemäß der Figuren 3A, 3B und 3C ist im Unterschied zu dem Bauelement gemäß der Figuren 1A und 1B eine torische oder bikonische plankonvexe Linse als refraktives optisches Element 12 verwendet. Die Außenseite 15 der plankonvexen Linse weist hierbei eine nach außen gewölbte konvexe Krümmung auf, die bevorzugt konisch ausgebildet ist. Weiterhin weist die Linse keine Rotationssymmetrie auf, sondern eine nahezu rechteckige Grundfläche, bei der die Ecken abgerundet sind. Das Bauelement gemäß der Figuren 3A, 3B und 3C ist dazu vorgesehen, einen rechteckigen Zielbereich 11 möglichst gleichmäßig auszuleuchten. Die Grundfläche der Linse 12 ist somit an den Zielbereich 11 angepasst.

Die Rückseite 18 der Linse 12, die zu dem Halbleiterkörper 1 gewandt ist, ist plan ausgebildet. Alternativ kann diese auch nach außen konvex gewölbt sein, wie beispielsweise bei dem refraktiven optischen Element 12 gemäß der Figuren 1A, 1B und 2. Eine nach außen konvex gewölbte Rückseite 18 der Linse bewirkt in der Regel vorteilhafterweise eine stärkere Bündelung der Strahlung.

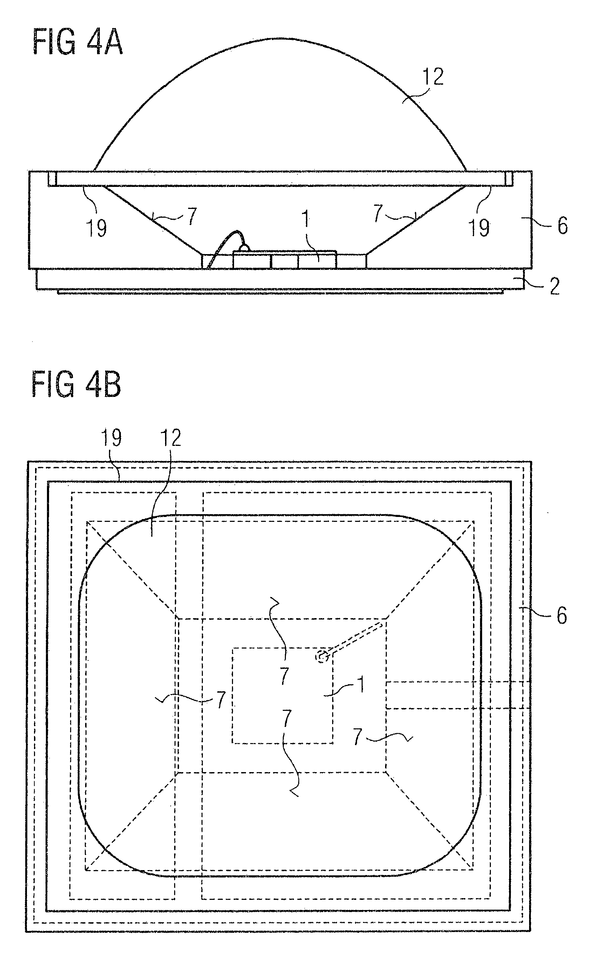

In den Figuren 4A und 4B sind beispielhaft mögliche Abmessungen für das Bauelement gemäß der Figuren 3A bis 3C gezeigt. So ist hier zu sehen, dass die gesamte Höhe des Bauelements vorteilhafterweise lediglich zirka 2 mm aufweist. Die Seiten des Bauelements weisen 3,8 mm und 3,7 mm auf. Das Substrat 2 weist vorliegend eine Dicke von ca. 0,15 mm auf.

Weiterhin ist, wie in Figur 4A gezeigt, das refraktive optische Element 12 in eine Aussparung 19 des reflektierenden optischen Elements 6 bündig eingepasst.

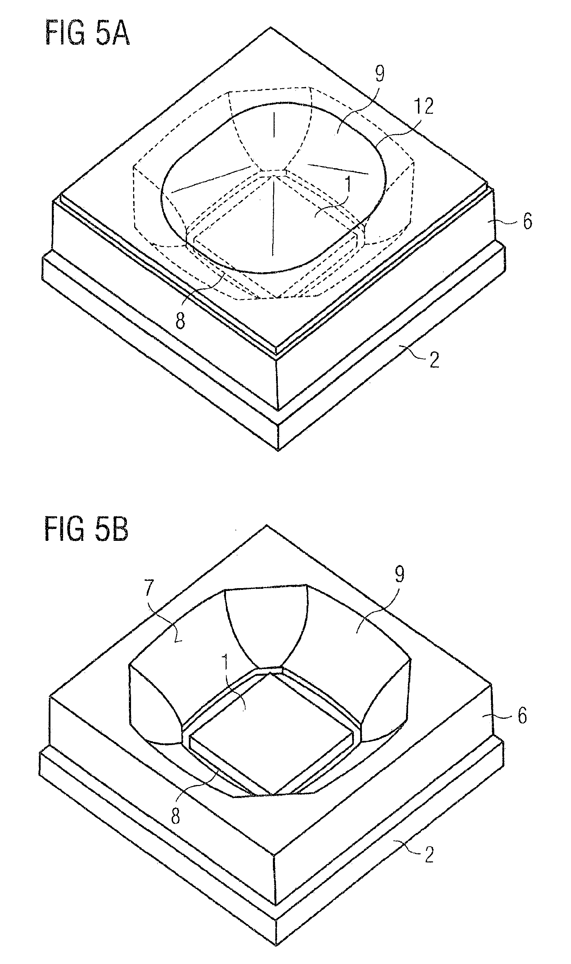

Das Bauelement gemäß dem Ausführungsbeispiel der Figuren 5A und 5B weist im Unterschied zu den vorangegangenen Bauelementen ein reflektierendes optisches Element 6 mit einer ersten Öffnung 8 und einer zweiten Öffnung 9 auf, die jeweils eine achteckige Fläche begrenzen. Weiterhin ist es auch möglich, dass die erste Öffnung 8 eine rechteckige Fläche und die zweite Öffnung 9 eine achteckige Fläche begrenzt.

Entsprechend der achteckigen Fläche, die durch die zweite Öffnung 9 begrenzt wird, weist das reflektierende optische Element 6 acht Seitenflächen 7 auf. Die Seitenflächen 7 verlaufen schräg zur ersten Öffnung 8 und zur zweiten Öffnung 9 und sind bevorzugt gekrümmt ausgebildet. Die Seitenflächen 7 sind dafür vorgesehen, Strahlung des Halbleiterkörpers 1, die von einem flachen Winkel α von dessen Vorderseite 4 emittiert wird, in einen Außenbereich 10 eines rechteckigen Zielbereiches 11 zu lenken. In Figur 5B ist weiterhin das refraktive Element 12 aus Gründen der Deutlichkeit weggelassen.

Als refraktives optisches Element 12 kann bei dem Bauelement gemäß der Figur 5A beispielsweise eine plankonvexe Linse verwendet sein, wie sie anhand der Figuren 3A, 3B und 3C bereits beschrieben wurde.

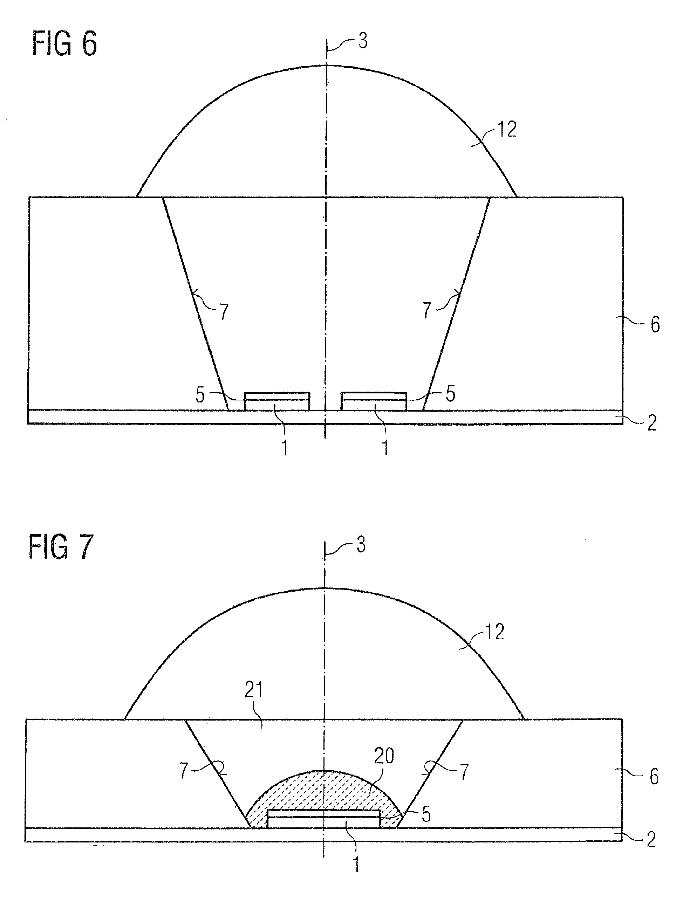

Das Bauelement gemäß der Figur 6 weist im Unterschied zu dem Ausführungsbeispiel der Figur 3A zwei Halbleiterkörper 1 auf, die nebeneinander symmetrisch zur optischen Achse 3 des Bauelements angeordnet sind. Das reflektierende optische Element 6 weist hierbei eine größere Höhe auf, als bei dem Bauelement gemäß der Figur 3A, um die größere Strahlungsaustrittsfläche aufgrund der beiden Halbleiterkörper 1 zu kompensieren. Als refraktives optisches Element 12 kann bei dem Bauelement gemäß der Figur 6 ebenfalls eine plankonvexe Linse verwendet sein, wie sie anhand der Figuren 3A, 3B und 3C bereits beschrieben wurde.

Das Bauelement gemäß der Figur 7 weist im Unterschied zu dem Bauelement der Figur 3A einen Verguss 20 auf, der den Halbleiterkörper 1 einbettet und eine Linse ausbildet. Der Verguss 20 füllt das Innere des reflektierenden optischen Elements 6 vorliegend nicht vollständig aus. Dies bedeutet, dass ein Strahl, der von der Vorderseite 4 des Halbleiterkörpers 1 ausgesandt wird, zuerst den Verguss 20 durchläuft, danach in den luftgefüllten Raum 21 zwischen Verguss 20 und refraktivem optischen Element 12 eintritt, um dann in das refraktive optische Element 12 zu gelangen. Von der Außenseite 15 des refraktiven optischen Elements 12 wird der Strahl schließlich ausgekoppelt.

Der Verguss 20 weist beispielsweise eines der folgenden Materialien auf oder besteht aus einem der folgenden Materialien: ein Silikon, ein Epoxid oder eine Mischung aus Silikon und Epoxid.

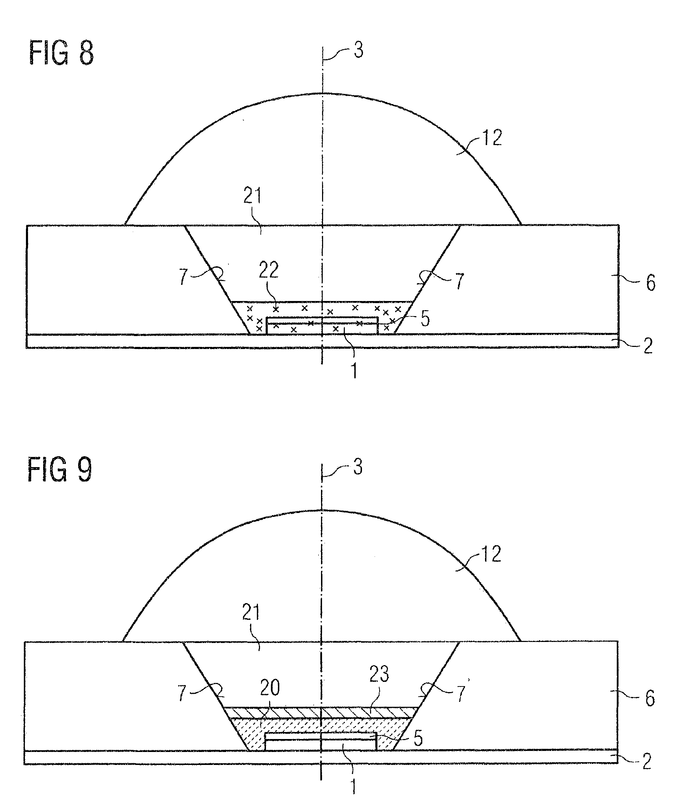

Das Bauelement gemäß der Figur 8 umfasst im Unterschied zur Figur 3A einen Wellenlängenkonversionsstoff 22, der dazu geeignet ist, einen Teil der Strahlung des Halbleiterkörpers 1 in Strahlung eines anderen Wellenlängenbereiches umzuwandeln. Bevorzugt emittiert der Halbleiterkörper 1 Strahlung aus dem blauen Spektralbereich, die von dem Wellenlängenkonversionsstoff 22 in Strahlung aus dem gelben Spektralbereich umgewandelt wird, so dass weißes Mischlicht entsteht. Ein Bauelement, das weißes Mischlicht emittiert, ist beispielsweise dazu geeignet, als Blitzlicht für eine Kamera in einem Mobiltelefon verwendet zu sein.

Der Wellenlängenkonversionsstoff 22 ist in ein Matrixmaterial, eingebracht, beispielsweise ein Silikon, ein Epoxid oder eine Mischung aus Silikon und Epoxid. Das Matrixmaterial mit dem Wellenlängenkonversionsstoff 22 umhüllt den Halbleiterkörper 1 und bildet eine plane Oberfläche über der Vorderseite des Halbleiterkörpers 1 aus. Zwischen dem Matrixmaterial mit dem Wellenlängenkonversionsstoff 22 und dem refraktiven Element 12 ist ein luftgefüllter Raum 21 vorhanden. Als refraktives Element 12 kann beispielsweise eine plankonvexe Linse verwendet sein, wie sie beispielsweise anhand der Figuren 3A, 3B und 3C bereits beschrieben wurde.

Alternativ zu dem planen, wellenlängenkonvertierenden Verguss des Halbleiterkörpers 1, wie er in Figur 8 gezeigt ist, ist es auch möglich, dass lediglich auf die Vorderseite 4 des Halbleiterkörpers 1 eine wellenlängenkonvertierende Schicht aufgebracht ist. Eine solche wellenlängenkonvertierende Schicht kann beispielsweise durch ein keramisches Plättchen oder ein Matrixmaterial, in das Partikel eines Wellenlängenkonversionsstoffs 22 eingebracht sind, gebildet sein. Ein Halbleiterkörper 1 mit einer wellenlängenkonvertierenden Schicht auf seiner Vorderseite 4 kann weiterhin beispielsweise von einem klaren Verguss 20 umhüllt sein, der frei von Wellenlängenkonversionsstoff 22 ist. Ein solcher klarer Verguss 20 kann das reflektierende optische Element 6 entweder vollständig oder nur teilweise ausfüllen. Weiterhin kann der Verguss 20 als Linse ausgebildet sein oder eine plane Oberfläche aufweisen.

Bei dem Bauelement gemäß der Figur 9 ist der Halbleiterkörper 1 im Unterschied zu dem Bauelement gemäß der Figur 3A mit einem klaren Verguss 20 versehen, der eine plane Oberfläche aufweist. Auf den Verguss 20 ist eine diffus streuende Schicht 23 aufgebracht, die dazu geeignet ist, einen weißen Farbeindruck bei einem externen Betrachter hervorzurufen. Insbesondere ist eine diffus streuende Schicht 23 auch in Verbindung mit einem Wellenlängenkonversionsstoff 22 verwendet, um einen Farbeindruck des Wellenlängenkonversionsstoffs 22 zu überdecken.

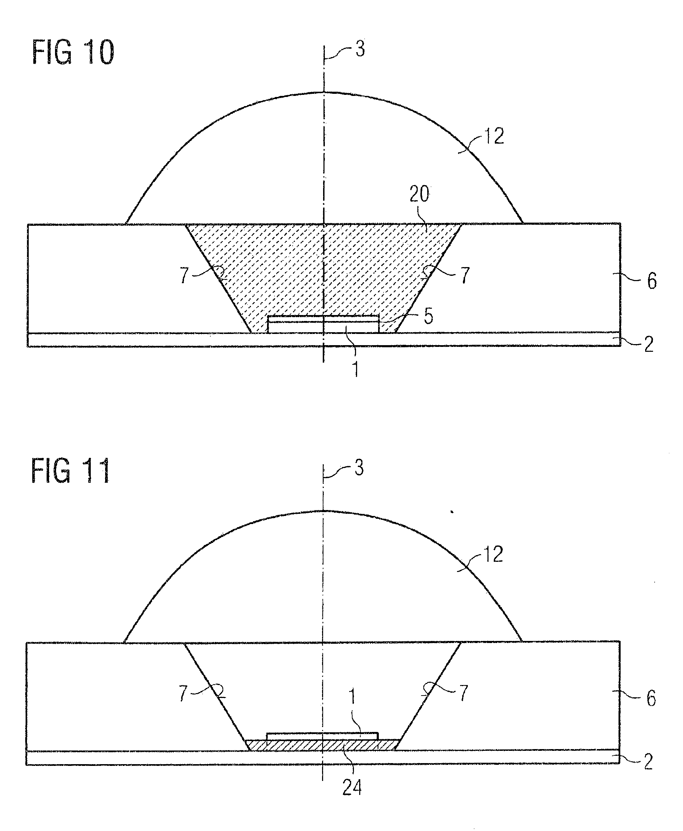

Bei dem Bauelement gemäß der Figur 10 ist der Halbleiterkörper im Unterschied zu dem Bauelement gemäß der Figur 3A in einen klaren Verguss 20 eingebettet, wobei der Verguss 20 das reflektierenden optische Element 6 vollständig ausfüllt. Der Verguss 20 bildet somit vorliegend eine gemeinsame Grenzfläche mit dem refraktiven optischen Element 12 aus und es existiert kein luftgefüllter Raum zwischen dem Verguss 20 und dem refraktiven optischen Element 12.

Bei dem Bauelement gemäß der Figur 11 ist der Halbleiterkörper 1 im Unterschied zu dem Bauelement gemäß der Figur 3A von einem hochreflektiven Verguss 24 umgeben. Dieser ist bevorzugt nicht höher als bis zur aktiven Zone 5 des Halbleiterkörpers 1 aufgefüllt.

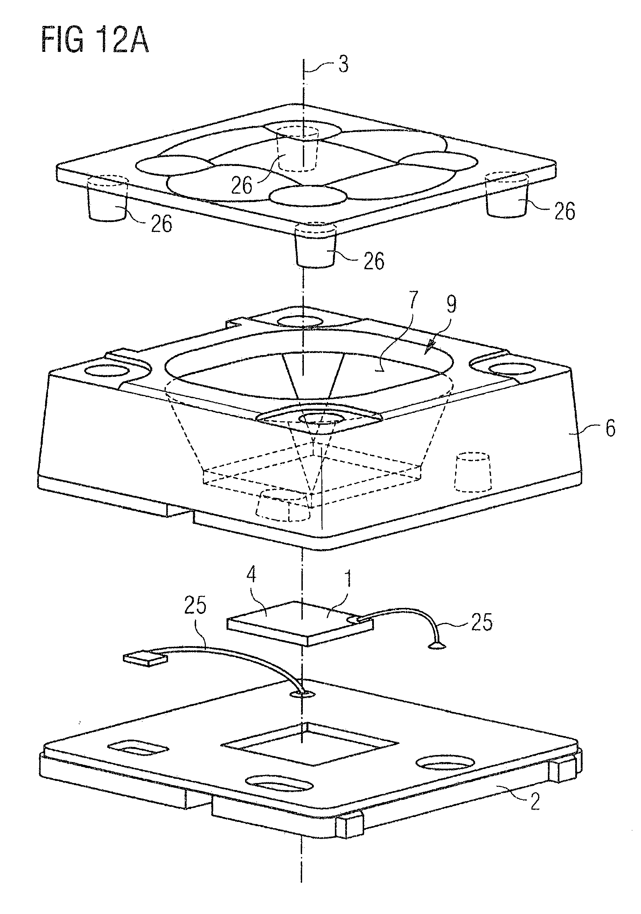

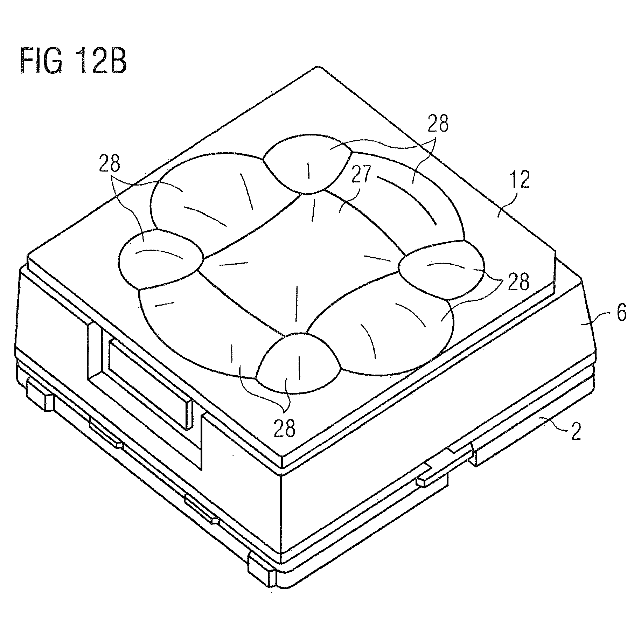

Das strahlungsemittierende Halbleiterbauelement gemäß der Figuren 12A und 12B weist ein Substrat 2 mit einer rechteckigen Grundfläche auf. Auf das Substrat 2 ist zentriert zur optischen Achse 3 ein Halbleiterkörper 1 angeordnet, der mit zwei Bonddrähten 25 elektrisch kontaktiert ist.

Auf dem Substrat 2 ist weiterhin ein reflektierendes optisches Element 6 angeordnet, das ebenfalls eine rechteckige Grundfläche aufweist. Das reflektierende optische Element 6 weist wie das reflektierende optische Element 6 gemäß dem Ausführungsbeispiel der Figuren 5A und 5B eine erste Öffnung 8 und eine zweite Öffnung 9 auf, die jeweils eine achteckige Fläche begrenzen. Entsprechend der achteckigen Fläche, die durch die zweite Öffnung 9 begrenzt wird, weist das reflektierende optische Element 6 acht schräge Seitenflächen 7 auf, die dazu vorgesehen sind, Strahlung, die unter einem flachen Winkel α von der Vorderseite 4 des Halbleiterkörpers 1 emittiert wird, in einen Außenbereich 10 eines rechteckigen Zielbereichs 11 zu lenken.

Auf dem reflektierenden optischen Element 6 ist vorliegend ein refraktives optisches Element 12 angeordnet. Das refraktive optische Element 12 weist jeweils in den Ecken seiner rechteckige Grundfläche einen Stift 26 auf, der dazu vorgesehen ist, in eine korrespondierende Ausnehmungen des refraktiven optischen Elementes 12 eingepasst zu werden.

Das refraktive optische Element 12 ist vorliegend als segmentierte Linse ausgebildet, wie insbesondere in Figur 12B zu sehen. Die segmentierte Linse weist vorliegend ein mittig angeordnetes zentrales erstes Segment 27 auf, das nach außen gewölbt ist. Beispielsweise kann die Wölbung dieses zentralen Segmentes 27 bikonisch oder gemäß einem (x,y)-Polynom ausgestaltet sein. Das zentrale Segment 27 des refraktiven optischen Elementes ist von weiteren äußeren Segmenten 28 umlaufend umgeben, die ebenfalls bikonisch nach außen gewölbt sind. Eine Umrandung des zentralen Segments 27 bildet hierbei jeweils mit einer Umrandung eines äußeren Segments 28 eine gemeinsame Grenzlinie aus. Das zentrale Segment 27 ist entsprechend der achteckigen Fläche, die durch die zweite Öffnung 9 begrenzt wird, von acht äußeren Linsensegmenten 28 umgeben. Die äußeren Linsensegmente 28 sind jeweils punktsymmetrisch zu einem Mittelpunkt des zentralen Segmentes 27 angeordnet, durch den die optische Achse 3 des Bauelements verläuft. Mit Hilfe der segmentierten Linse ist es insbesondere möglich, einen rechteckigen Zielbereich möglichst homogen auszuleuchten.

Die vorliegende Anmeldung beansprucht die Priorität der deutschen Anmeldung DE 10 2010 027 212.

Die Erfindung ist nicht durch die Beschreibung anhand der Ausführungsbeispiele auf diese beschränkt. Vielmehr ist die Erfindung durch den Anspruchsbereich der folgenden Ansprüche definiert.

## Patentansprüche

1. Strahlungsemittierendes Bauelement mit:
- einem Halbleiterkörper (1), der dazu vorgesehen ist, elektromagnetische Strahlung von seiner Vorderseite (4) auszusenden,
- einem reflektierenden optischen Element (6) mit mehreren schrägen, reflektierenden Seitenflächen, die umlaufend um den Halbleiterkörper angeordnet sind, und
- einem refraktiven optischen Element (12), das dem reflektierenden optischen Element in Abstrahlrichtung des Halbleiterkörpers nachgeordnet ist, wobei
- ein erster Teil der Strahlung des Halbleiterkörpers (1), der unter einem auf die Vorderseite (4) bezogenen flachen Winkel kleiner oder gleich 60 ° von der Vorderseite (4) des Halbleiterkörpers (1) ausgesandt wird, auf das reflektierende Element (6) trifft, von dem reflektierenden Element (6) in einen Außenbereich (10) eines Zielbereichs (11) gelenkt wird, und dabei einen äußeren Bereich des refraktiven optischen Elements (12) durchläuft,
- ein zweiter Teil der Strahlung des Halbleiterkörpers (1), der unter einem vergleichsweise auf die Vorderseite (4) bezogenen steilen Winkel von der Vorderseite (4) des Halbleiterkörpers (1) ausgesandt wird, direkt durch das refraktive Element (12) tritt ohne zuerst auf das reflektierende optische Element (6) aufzutreffen und von dem refraktiven Element (12) in einen Innenbereich (13) eines Zielbereichs (11) gebündelt wird, und
- eine erste und/oder zweite Öffnung (8,9) des reflektierenden Elements (6), die von den schrägen Seitenflächen des reflektierenden Elements (6) begrenzt wird, eine achteckige Fläche begrenzt.

2. Strahlungsemittierendes Bauelement nach dem vorherigen Anspruch, bei dem zumindest eine schräge Seitenfläche des reflektierenden optischen Elements gekrümmt ausgebildet ist.

3. Strahlungsemittierendes Bauelement nach einem der obigen Ansprüche, bei dem die Form des refraktiven optischen Elements (12) und/oder des reflektierenden optischen Elements (6) an die Form eines Zielbereichs (11) angepasst ist.

4. Strahlungsemittierendes Bauelement nach dem vorherigen Anspruch, bei dem der Zielbereich (11) durch eine rechteckige Fläche gegeben ist.

5. Strahlungsemittierendes Bauelement nach einem der obigen Ansprüche, bei dem als refraktives optisches Element (12) eine Fresnellinse, eine bikonische Linse, eine torische Linse, eine Linse mit einer Außenfläche gemäß einem x,y-Polynom, eine Plankonvexlinse, eine Bikonvexlinse, ein Linsenarray oder eine segmentierte Linse eingesetzt ist.

6. Strahlungsemittierendes Bauelement nach einem der obigen Ansprüche, bei dem das refraktive optische Element (12) eine quadrantensymmetrische Form aufweist.

7. Strahlungsemittierendes Bauelement nach einem der obigen Ansprüche, bei dem der Halbleiterkörper (1) in einen Verguss (20) eingebettet ist.

8. Strahlungsemittierendes Bauelement nach dem vorherigen Anspruch, bei dem der Verguss (20) als Linse ausbildet ist.

9. Strahlungsemittierendes Bauelement nach Anspruch 7, bei dem der Verguss (20) als Schicht ausbildet ist.

10. Strahlungsemittierendes Bauelement nach einem der obigen Ansprüche, das einen Wellenlängenkonversionsstoff (22) aufweist, der einen Teil der von dem Halbleiterkörper (1) erzeugten Strahlung in Strahlung eines anderen Wellenlängenbereichs umwandelt.

11. Strahlungsemittierendes Bauelement nach einem der obigen Ansprüche, bei dem in der Umgebung des Halbleiterkörpers (1) ein reflektiver Verguss (24) angeordnet ist.

12. Strahlungsemittierendes Bauelement nach einem der obigen Ansprüche, das zwei oder mehr strahlungsemittierende Halbleiterkörper (1) aufweist.

13. Strahlungsemittierenden Bauelement nach einem der obigen Ansprüche, bei dem das Verhältnis zwischen der maximalen Höhe des Bauelements zur Breite des Halbleiterkörpers (1) zwischen 1,5 und 3 liegt, wobei die Grenzen eingeschlossen sind.

## Claims

1. Radiation-emitting component comprising:
- a semiconductor body (1), which is provided for emitting electromagnetic radiation from its front side (4),
- a reflective optical element (6) having a plurality of oblique, reflective side surfaces arranged circumferentially around the semiconductor body, and
- a refractive optical element (12), which is disposed downstream of the reflective optical element in the emission direction of the semiconductor body, wherein
- a first part of the radiation of the semiconductor body (1), which is emitted from the front side (4) of the semiconductor body (1) at a shallow angle of less than or equal to 60° relative to the front side (4), impinges on the reflective element (6), is directed into an outer region (10) of a target region (11) by the reflective element (6) and in the process passes through an outer region of the refractive optical element (12),
- a second part of the radiation of the semiconductor body (1), which is emitted from the front side (4) of the semiconductor body (1) at a comparatively steep angle relative to the front side (4), passes directly through the refractive element (12) without first impinging on the reflective optical element (6) and is concentrated into an inner region (13) of a target region (11) by the refractive element (12), and
- a first and/or second opening (8, 9) of the reflective element (6), which are/is delimited by the oblique side surfaces of the reflective element (6), delimits an octagonal surface.

2. Radiation-emitting component according to the preceding claim, wherein at least one oblique side surface of the reflective optical element is embodied in a curved fashion.

3. Radiation-emitting component according to either of the preceding claims, wherein the shape of the refractive optical element (12) and/or of the reflective optical element (6) is adapted to the shape of a target region (11).

4. Radiation-emitting component according to the preceding claim, wherein the target region (11) is provided by a rectangular surface.

5. Radiation-emitting component according to any of the preceding claims, wherein a Fresnel lens, a biconic lens, a toric lens, a lens having an outer surface in accordance with an x,y-polynomial, a planoconvex lens, a biconvex lens, a lens array or a segmented lens is used as the refractive optical element (12).

6. Radiation-emitting component according to any of the preceding claim, wherein the refractive optical element (12) has a quadrant-symmetrical shape.

7. Radiation-emitting component according to any of the preceding claims, wherein the semiconductor body (1) is embedded into a potting (20).

8. Radiation-emitting component according to the preceding claim, wherein the potting (20) is embodied as a lens.

9. Radiation-emitting component according to Claim 7, wherein the potting (20) is embodied as a layer.

10. Radiation-emitting component according to any of the preceding claims, which comprises a wavelength conversion substance (22) that converts part of the radiation generated by the semiconductor body (1) to radiation in a different wavelength range.

11. Radiation-emitting component according to any of the preceding claims, wherein a reflective potting (24) is arranged in the surroundings of the semiconductor body (1).

12. Radiation-emitting component according to any of the preceding claims, which comprises two or more radiation-emitting semiconductor bodies (1).

13. Radiation-emitting component according to any of the preceding claims, wherein the ratio between the maximum height of the component and the width of the semiconductor body (1) is between 1.5 and 3, inclusive of the limits.

## Revendications

1. Composant émetteur de rayonnement, avec :
- un corps semi-conducteur (1) prévu pour émettre un rayonnement électromagnétique à partir de sa face avant (4),
- un élément optique réfléchissant (6) avec plusieurs surfaces latérales réfléchissantes obliques agencées de façon circonférentielle autour du corps semi-conducteur, et
- un élément optique réfractif (12) agencé en aval de l'élément optique réfléchissant dans la direction de rayonnement du corps semi-conducteur, dans lequel
- une première partie du rayonnement du corps semi-conducteur (1), émise à partir de la face avant (4) du corps semi-conducteur (1) sous un angle plat inférieur ou égal à 60° par rapport à la face avant (4), rencontre l'élément réfléchissant (6), est dirigée depuis l'élément réfléchissant (6) vers une région extérieure (10) d'une région cible (11), et traverse ce faisant une région extérieure de l'élément optique réfractif (12),
- une deuxième partie du rayonnement du corps semi-conducteur (1), émise à partir de la face avant (4) du corps semi-conducteur (1) sous un angle relativement aigu par rapport à la face avant (4), traverse directement l'élément réfractif (12) sans rencontrer préalablement l'élément optique réfléchissant (6), et est focalisée vers une région intérieure (13) d'une région cible (11) à partir de l'élément réfractif (12), et
- une première et/ou une deuxième ouverture (8, 9) de l'élément réfléchissant (6), laquelle/lesquelles est/sont délimitée(s) par les surfaces latérales obliques de l'élément réfléchissant (6), délimite(nt) une surface octogonale.

2. Composant émetteur de rayonnement selon la revendication précédente, dans lequel au moins une surface latérale oblique de l'élément optique réfléchissant est conçue de façon incurvée.

3. Composant émetteur de rayonnement selon l'une des revendications précédentes, dans lequel la forme de l'élément optique réfractif (12) et/ou de l'élément optique réfléchissant (6) est adaptée à la forme d'une région cible (11).

4. Composant émetteur de rayonnement selon la revendication précédente, dans lequel la région cible (11) est définie par une surface rectangulaire.

5. Composant émetteur de rayonnement selon l'une des revendications précédentes, dans lequel l'élément optique réfractif (12) utilisé est une lentille de Fresnel, une lentille biconique, une lentille torique, une lentille avec une surface extérieure correspondant à un polynôme x,y, une lentille plan-convexe, une lentille biconvexe, un ensemble de lentilles ou une lentille segmentée.

6. Composant émetteur de rayonnement selon l'une des revendications précédentes, dans lequel l'élément optique réfractif (12) présente une forme symétrique en quadrant.

7. Composant émetteur de rayonnement selon l'une des revendications précédentes, dans lequel le corps semi-conducteur (1) est enrobé dans une masse de scellement (20).

8. Composant émetteur de rayonnement selon la revendication précédente, dans lequel la masse de scellement (20) est conçue comme une lentille.

9. Composant émetteur de rayonnement selon la revendication 7, dans lequel la masse de scellement (20) est conçue comme une couche.

10. Composant émetteur de rayonnement selon l'une des revendications précédentes, comprenant une matière de conversion de longueur d'onde (22) convertissant une partie du rayonnement produit par le corps semi-conducteur (1) en un rayonnement d'une autre plage de longueurs d'ondes.

11. Composant émetteur de rayonnement selon l'une des revendications précédentes, dans lequel une masse de scellement réfléchissante (24) est disposée dans l'environnement du corps semi-conducteur (1).

12. Composant émetteur de rayonnement selon l'une des revendications précédentes, comprenant deux ou plus de deux corps semi-conducteurs (1) émetteurs de rayonnement.

13. Composant émetteur de rayonnement selon l'une des revendications précédentes, dans lequel le rapport entre la hauteur maximale du composant et la largeur du corps semi-conducteur (1) est compris entre 1,5 et 3, bornes incluses.
